(19) Europäisches Patentamt
European Patent Office
Office européen des brevets

(11) **EP 3 496 135 B1**

(12) **FASCICULE DE BREVET EUROPEEN**

(45) Date de publication et mention
de la délivrance du brevet:
**02.07.2025 Bulletin 2025/27**

(21) Numéro de dépôt: **18209604.0**

(22) Date de dépôt: **30.11.2018**

(51) Classification Internationale des Brevets (IPC):
**H01L 21/762** (2006.01)    **H01L 21/20** (2006.01)

(52) Classification Coopérative des Brevets (CPC):
**H01L 21/76254;** H01L 21/2007

(54) **PROCEDE DE COLLAGE PAR ADHESION DIRECTE**

KLEBEVERFAHREN DURCH DIREKTADHÄSION

METHOD OF BONDING BY DIRECT ADHESION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.12.2017 FR 1761829**

(43) Date de publication de la demande:
**12.06.2019 Bulletin 2019/24**

(73) Titulaire: **Commissariat à l'Energie Atomique et aux Energies Alternatives**
**75015 Paris (FR)**

(72) Inventeurs:
• FOURNEL, Frank
**38190 VILLARD-BONNOT (FR)**
• MAZEN, Frédéric
**38120 SAINT-EGREVE (FR)**

(74) Mandataire: **INNOV-GROUP**
**209 Avenue Berthelot**
**69007 Lyon (FR)**

(56) Documents cités:
US-A1- 2014 235 031    US-A1- 2015 194 337
US-A1- 2016 233 125    US-A1- 2017 133 347

## Description

### Domaine technique

L'invention se rapporte au domaine technique du collage par adhésion directe de deux substrats.

L'invention trouve notamment son application dans le transfert de couches minces par la technologie Smart Cut™.

### Etat de la technique antérieure

Si l'on considère un procédé de collage par adhésion directe d'un premier substrat à un deuxième substrat, issu de la mise en contact direct de deux surfaces, il est connu qu'un tel procédé est susceptible de conduire à une inhomogénéité de l'énergie d'adhérence (appelée également énergie de collage, et exprimée en J/m$^2$), c'est-à-dire l'énergie pour séparer les deux surfaces après leur collage. En particulier, cette inhomogénéité de l'énergie d'adhérence se traduit par une énergie d'adhérence plus faible sur les bords des deux surfaces que sur une partie centrale des deux surfaces. A titre d'exemple, la différence d'énergie d'adhérence entre les bords (par exemple sur une distance de 1 cm) et une partie centrale des deux surfaces peut s'élever à 700 mJ/m$^2$ pour deux substrats de silicium, recouverts d'une couche d'oxyde, et possédant chacun un diamètre de 200 mm.

En outre, dans le cas du transfert de couches minces par la technologie Smart Cut™, une forte inhomogénéité de l'énergie d'adhérence peut conduire à un décollement des deux substrats lors de l'étape de fracturation avec la présence de zones non-transférées et de défauts.

L'homme du métier recherche donc un procédé de collage par adhésion directe permettant d'obtenir une énergie d'adhérence des surfaces en contact la plus homogène possible.

Les documents US 2016/233125 A1, US 2017/133347 A1, US 2015/194337 A1 et US 2014/235031 A1 divulguent des exemples de procédés de collage direct utilisant un taux d'humidité contrôlé.

### Exposé de l'invention

L'invention vise à remédier en tout ou partie aux inconvénients précités. A cet effet, l'invention a pour objet un procédé de collage par adhésion directe d'un premier substrat à un deuxième substrat, comportant les étapes successives :

a) prévoir les premier et deuxième substrats, comprenant chacun une première surface et une seconde surface opposée ;
b) coller le premier substrat au deuxième substrat par une adhésion directe entre les premières surfaces des premier et deuxième substrats, l'étape b) étant exécutée à une température comprise entre 20°C et sous une première atmosphère gazeuse présentant un premier taux d'humidité relative, noté $\varphi_1$ ;
c) appliquer un recuit thermique aux premier et deuxième substrats collés, à une température de recuit thermique comprise entre 100°C et 700°C, l'étape c) étant exécutée sous une seconde atmosphère gazeuse présentant un second taux d'humidité relative, noté $\varphi_2$, vérifiant $\varphi_2 \geq \varphi_1$.

Ainsi, un tel procédé selon l'invention permet, grâce à l'étape c), une amélioration significative de l'homogénéité de l'énergie d'adhérence des premières surfaces des premier et deuxième substrats. En effet, les inventeurs ont constaté expérimentalement que la quantité de vapeur d'eau au sein de l'atmosphère du recuit thermique avait un impact sur l'homogénéité de l'énergie d'adhérence. Plus précisément, le fait d'au moins maintenir le taux d'humidité relative après l'étape b) de collage permet d'améliorer significativement l'homogénéité de l'énergie d'adhérence en évitant que l'eau présente à l'interface de collage, en bordure de substrat, ne diffuse hors de l'interface de collage. Autrement dit, les premier et second substrats collés sont maintenus après l'étape b), y compris lors de l'exécution de l'étape c), sous une atmosphère présentant un taux d'humidité supérieur ou égal à $\varphi_1$, de manière à homogénéiser l'énergie d'adhérence des premières surfaces des premier et deuxième substrats.

### **Définitions**

- Par « substrat », on entend un support physique autoporté, réalisé dans un matériau de base permettant la fabrication d'un dispositif électronique ou d'un composant électronique. Un substrat est classiquement une tranche (« *wafer* » en langue anglaise) découpée dans un lingot monocristallin de matériau semi-conducteur.
- Par « adhésion directe », on entend un collage spontané issu de la mise en contact de deux surfaces, c'est-à-dire en l'absence d'un élément additionnel tel qu'une colle, une cire ou une brasure. L'adhésion provient principalement des forces de van der Waals issues de l'interaction électronique entre les atomes ou les molécules de deux surfaces, des liaisons hydrogène du fait des préparations des surfaces ou des liaisons covalentes établies entre les deux surfaces. On parle également de collage par adhésion moléculaire ou de collage direct. Le collage par adhésion directe est avantageusement effectué à température et pression ambiantes, et ne saurait être assimilé à un collage par thermocompression, à un collage eutectique, ou encore à un collage anodique. Le collage par adhésion directe peut être suivi d'un recuit thermique de renforcement de l'interface de collage.

- Par « recuit thermique », on entend un traitement thermique comportant un cycle de chauffage avec :

    une première phase de montée graduelle en température jusqu'à atteindre une valeur plateau,
    une deuxième phase où la température de chauffage conserve la valeur plateau, et
    une troisième phase de refroidissement.

La température du recuit thermique est la valeur plateau de la température de chauffage.

- Par « taux d'humidité relative », on entend le rapport (exprimé en %) entre la quantité de vapeur d'eau contenue dans un volume de gaz donné, et la quantité maximale de vapeur d'eau admissible dans le volume de gaz donné. Le taux d'humidité relative dépend de la température du gaz et de la pression du gaz. Le taux d'humidité relative peut également s'exprimer comme le rapport (exprimé en %) entre la pression partielle de la vapeur d'eau contenue dans un volume de gaz, et la pression de vapeur saturante de l'eau.

Le procédé selon l'invention peut comporter une ou plusieurs des caractéristiques suivantes.

Selon une caractéristique de l'invention, l'eau possède une pression de vapeur saturante au sein de la seconde atmosphère gazeuse, notée $P_{sat}$, et l'étape c) comporte les étapes :

    $c_1$) augmenter progressivement une température de chauffage de la seconde atmosphère gazeuse jusqu'à atteindre la température de recuit thermique ;
    $c_2$) mesurer des températures de chauffage progressives au cours de l'étape $c_1$), et déterminer $P_{sat}$ pour les températures de chauffage progressives mesurées ;
    $c_3$) augmenter progressivement, au cours de l'étape $c_1$), la pression partielle de vapeur d'eau, notée $p_v$, au sein de la seconde atmosphère gazeuse de sorte que $p_v \geq P_{sat} \, \varphi_1$.

Ainsi, il est possible d'ajuster $\varphi_2$ (égal au rapport entre $p_v$ et $P_{sat}$) tout le long de l'étape $c_1$) de montée en température de sorte que la relation $\varphi_2 \geq \varphi_1$ puisse se vérifier.

Selon une caractéristique de l'invention, $\varphi_2$ est égal à 100%.

Ainsi, un avantage procuré est de simplifier le procédé en saturant la seconde atmosphère gazeuse de vapeur d'eau, et ce afin de s'assurer que la relation $\varphi_2 \geq \varphi_1$ est toujours vérifiée.

Selon une caractéristique de l'invention, l'étape c) est exécutée de sorte que la seconde atmosphère gazeuse présente une pression constante.

Ainsi, un avantage procuré est de simplifier l'ajustement de $\varphi_2$ qui dépend également de la pression de la seconde atmosphère gazeuse.

Selon une caractéristique de l'invention, les première et seconde atmosphères gazeuses comportent de l'air.

Selon une caractéristique de l'invention, l'étape c) est exécutée dans un four injectant une vapeur d'eau, produite par ultrasons, dans la seconde atmosphère gazeuse.

Ainsi, un avantage procuré par l'injection de vapeur d'eau produite par ultrasons est de pouvoir s'intégrer facilement à un four qui, classiquement, n'autorise que des atmosphères sèches pour des températures relativement basses (i.e. inférieures à 700°C).

Selon une caractéristique de l'invention, la température de recuit thermique est comprise entre 100°C et 500°C, plus préférentiellement comprise entre 200°C et 400°C, encore plus préférentiellement comprise entre 250°C et 350°C.

Selon une caractéristique de l'invention, l'étape a) comporte une étape $a_1$) consistant à implanter des espèces gazeuses dans le premier substrat, à travers la première surface, de manière à former une zone de fragilisation, une couche utile étant délimitée par la zone de fragilisation et par la première surface du premier substrat ; et le recuit thermique est appliqué lors de l'étape c) selon un budget thermique adapté pour fracturer le premier substrat suivant la zone de fragilisation de manière à exposer la couche utile.

Ainsi, un avantage procuré est de pouvoir transférer la couche utile sur le deuxième substrat par Smart Cut™.

Selon une caractéristique de l'invention, l'étape a) comporte une étape $a_1$) consistant à implanter des espèces gazeuses dans le premier substrat, à travers la première surface, de manière à former une zone de fragilisation, une couche utile étant délimitée par la zone de fragilisation et par la première surface du premier substrat ; et l'étape c) est suivie d'une étape d) consistant à fracturer le premier substrat suivant la zone de fragilisation de manière à exposer la couche utile.

Ainsi, le recuit thermique peut être appliqué lors de l'étape c) selon un budget thermique correspondant à une fraction (e.g. entre 50% et 80%) du budget thermique nécessaire pour fracturer le premier substrat suivant la zone de fragilisation. Un tel budget thermique de l'étape c) permet d'assurer un collage fort en bord de substrat de sorte que l'étape d) puisse être exécutée sous une atmosphère moins humide, voire sèche. L'étape d) peut être exécutée par un traitement thermique complémentaire, adapté pour obtenir la fracture du premier substrat suivant la zone de fragilisation.

Selon une caractéristique de l'invention, les premières surfaces des premier et deuxième substrats sont réalisées dans un matériau sélectionné parmi Si,

$SiO_2$, Ge, $Al_2O_3$, SiC, AsGa, InP, GaN, $LiNbO_3$, $LiTaO_3$.

Selon l'invention, l'étape b) est exécutée à une température comprise entre 20°C et 30°C.

## Brève description des dessins

D'autres caractéristiques et avantages apparaîtront dans l'exposé détaillé de différents modes de réalisation de l'invention, l'exposé étant assorti d'exemples et de références aux dessins joints.

Figure 1 est une vue schématique en coupe selon la normale aux premières surfaces -et secondes surfaces- des premier et deuxième substrats, illustrant l'étape c) d'un procédé selon l'invention.

Figure 2 est un graphique représentant en abscisses la température (en °C) et en ordonnées la pression de vapeur saturante de l'eau (en bars, en échelle logarithmique), obtenu par la formule de Clapeyron.

Figures 3a à 3e sont des vues schématiques en coupe selon la normale aux premières surfaces -et secondes surfaces- des premier et deuxième substrats, illustrant des étapes d'un procédé selon l'invention dans le cas d'un transfert de couche utile par la technologie Smart Cut™.

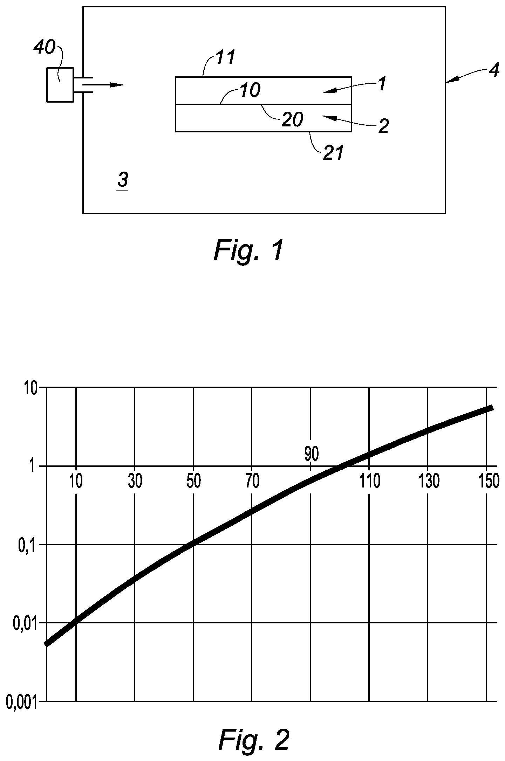

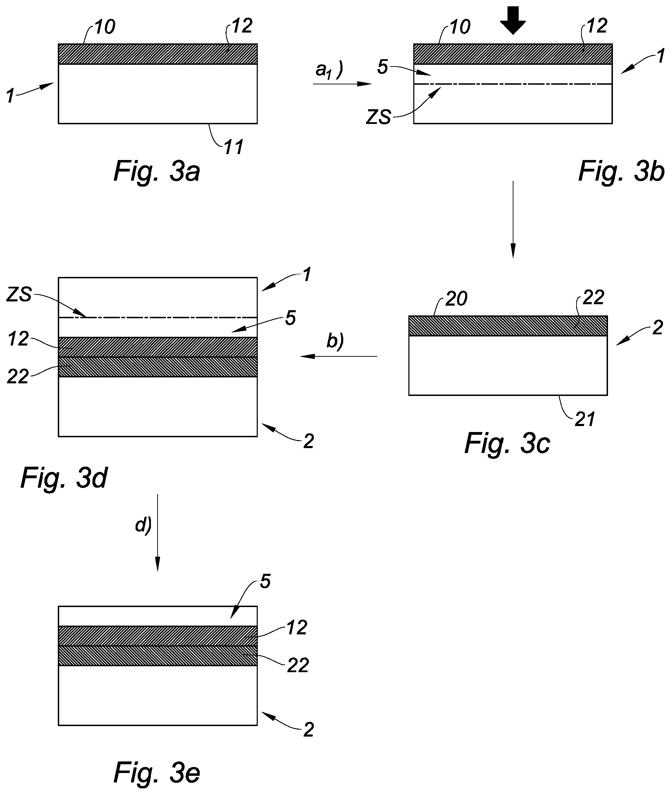

Figure 1 et Figures 3a à 3e ne sont pas représentées à l'échelle pour en simplifier leur compréhension.

## Exposé détaillé des modes de réalisation

Les éléments identiques ou assurant la même fonction porteront les mêmes références pour les différents modes de réalisation, par souci de simplification.

Un objet de l'invention est un procédé de collage par adhésion directe d'un premier substrat 1 à un deuxième substrat 2, comportant les étapes successives :

a) prévoir les premier et deuxième substrats 1, 2, comprenant chacun une première surface 10, 20 et une seconde surface 11, 21 opposée ;

b) coller le premier substrat 1 au deuxième substrat 2 par une adhésion directe entre les premières surfaces 10, 20 des premier et deuxième substrats 1, 2, l'étape b) étant exécutée à une température comprise entre 20°C et 30°C sous une première atmosphère gazeuse présentant un premier taux d'humidité relative, noté $\varphi_1$ ;

c) appliquer un recuit thermique aux premier et deuxième substrats 1, 2 collés, à une température de recuit thermique comprise entre 100°C et 700°C, l'étape c) étant exécutée sous une seconde atmosphère gazeuse 3 présentant un second taux d'humidité relative, noté $\varphi_2$, vérifiant $\varphi_2 \geq \varphi_1$.

## Premier et deuxième substrats

Les premier et/ou deuxième substrats 1, 2 peuvent être réalisés dans un matériau semi-conducteur. Les premier et/ou deuxième substrats 1, 2 peuvent comporter une couche superficielle 12, 22 telle qu'une couche d'oxyde, comme illustrée aux figures 3a à 3e.

Les premières surfaces 10, 20 des premier et deuxième substrats 1, 2 sont avantageusement réalisées dans un matériau sélectionné parmi Si, $SiO_2$, Ge, $Al_2O_3$, SiC, AsGa, InP, GaN, $LiNbO_3$, $LiTaO_3$.

## Etape b) de collage

La première atmosphère gazeuse peut comporter de l'air. L'étape b) est exécutée à température ambiante, c'est-à-dire une température comprise entre 20°C et 30°C. L'étape b) peut être exécutée à pression ambiante ou sous vide.

## Etape c) de recuit thermique

La seconde atmosphère gazeuse 3 peut comporter de l'air. L'étape c) est avantageusement exécutée de sorte que la seconde atmosphère gazeuse 3 présente une pression constante. Comme illustré à la figure 1, l'étape c) est avantageusement exécutée dans un four 4 injectant, à l'aide d'un injecteur 40, une vapeur d'eau dans la seconde atmosphère gazeuse 3. La vapeur d'eau est avantageusement produite par ultrasons. La température de recuit thermique est avantageusement comprise entre entre 100°C et 500°C, plus préférentiellement comprise entre 200°C et 400°C, encore plus préférentiellement comprise entre 250°C et 350°C. La température de recuit thermique est comprise entre 100°C et 700°C.

Selon un premier mode de mise en œuvre, l'eau possède une pression de vapeur saturante au sein de la seconde atmosphère gazeuse 3, notée $P_{sat}$, et l'étape c) comporte les étapes :

$c_1$) augmenter progressivement une température de chauffage de la seconde atmosphère gazeuse 3 jusqu'à atteindre la température de recuit thermique ;

$c_2$) mesurer des températures de chauffage progressives au cours de l'étape $c_1$), et déterminer $P_{sat}$ pour les températures de chauffage progressives mesurées ;

$c_3$) augmenter progressivement, au cours de l'étape $c_1$), la pression partielle de vapeur d'eau, notée $p_v$, au sein de la seconde atmosphère gazeuse de sorte que $p_v \geq P_{sat} \varphi_1$.

L'étape $c_1$) est exécutée de sorte que la température de chauffage suit une rampe de température, par exemple de l'ordre de 10°C/min.

Comme illustré à la figure 2, l'étape $c_2$) peut comporter une étape consistant à déterminer $P_{sat}$ en fonction d'une température T quelconque, par exemple à l'aide de la formule de Clapeyron :

$$P_{sat}(T) = P_0 \exp\left(\frac{LM}{R}\left(\frac{1}{T_0} - \frac{1}{T}\right)\right)$$

où :

- $P_0$ est la pression de référence, égale à 1013,25 hPa ;
- L est la chaleur latente de vaporisation de l'eau (à 20°C), égale à 2470 kJ/kg ;
- M est la masse molaire de l'eau, égale à 0,01801 kg/mol ;
- R est la constante universelle des gaz parfaits, égale à 8,314 462 1 J.mol$^{-1}$K$^{-1}$ ;
- $T_0$ est la température de référence, égale à 373, 15 K (100°C).

$P_{sat}$ peut donc être déterminée en injectant la valeur de la température de chauffage mesurée dans la formule de Clapeyron.

L'étape $c_3$) est exécutée en ajustant le débit de l'injecteur 40.

Selon un deuxième mode de mise en œuvre, l'étape c) est exécutée de manière à saturer la seconde atmosphère gazeuse 3 de vapeur d'eau de sorte que $\varphi_2$ est égal à 100%. Autrement dit, l'étape c) est exécutée en injectant suffisamment de vapeur d'eau, à l'aide de l'injecteur 40, et en permanence -i.e. pendant toute la durée de l'étape c)-, dans la seconde atmosphère gazeuse 3 de sorte que $\varphi_2$ est égal à 100%.

**Application au transfert de couches minces**

L'étape a) peut comporter une étape $a_1$) consistant à implanter des espèces gazeuses dans le premier substrat 1 (appelé substrat donneur), à travers la première surface 10, de manière à former une zone de fragilisation ZS, une couche utile 5 à transférer (i.e. à transférer sur le deuxième substrat 2, appelé substrat support) étant délimitée par la zone de fragilisation ZS et par la première surface 10 du premier substrat 1. Les espèces gazeuses implantées lors de l'étape $a_1$) comportent préférentiellement des atomes d'hydrogène ionisée. Il est également possible d'effectuer une co-implantation avec d'autres espèces gazeuses telles que l'hélium. A titre d'exemple non limitatif, lorsque le premier substrat 1 est réalisé en silicium, l'étape $a_1$) peut être exécutée avec des atomes d'hydrogène ionisé selon les paramètres suivants :

- une énergie de 85 keV,
- une dose de 5x10$^{16}$ at.cm$^{-2}$.

Le recuit thermique est avantageusement appliqué lors de l'étape c) selon un budget thermique adapté pour fracturer le premier substrat 1 suivant la zone de fragilisation ZS de manière à exposer la couche utile 5. A cet effet, la température de recuit thermique de l'étape c) peut être comprise entre 250°C et 600°C, voire comprise entre 350°C et 500°C.

Selon une variante, le procédé comporte une étape d) consistant à fracturer le premier substrat 1 suivant la zone de fragilisation ZS de manière à exposer la couche utile 5, l'étape d) étant exécutée après l'étape c). Le recuit thermique peut alors être appliqué lors de l'étape c) selon un budget thermique correspondant à une fraction (e.g. entre 50% et 80%) du budget thermique nécessaire pour fracturer le premier substrat 1 suivant la zone de fragilisation ZS. Un tel budget thermique de l'étape c) permet d'assurer un collage fort en bord de substrat de sorte que l'étape d) de fracture (« *splitting*» en langue anglaise) puisse être exécutée sous une atmosphère moins humide, voire sèche. L'étape d) peut être exécutée par un traitement thermique complémentaire, adapté pour obtenir la fracture du premier substrat 1 suivant la zone de fragilisation ZS.

**Exemple de mise en œuvre n°1**

Les premier et deuxième substrats 1, 2 sont deux tranches de silicium <001> de 300 mm de diamètre et de 775 μm d'épaisseur. Un des deux substrats 1, 2 comporte une couche superficielle 12, 22 d'oxyde obtenue par oxydation thermique, et d'une épaisseur de 145 nm. Les premier et deuxième substrats 1, 2 sont nettoyés et hydrolysés dans des bains d'eau déionisée enrichie en ozone dans une solution d'APM (« *Ammonia-Peroxyde Mixture* ») à 70°C.

Les premier et deuxième substrats 1, 2 sont collés lors de l'étape b) par adhésion directe à température ambiante, et à pression ambiante. La première atmosphère gazeuse (air ambiant) présente un premier taux d'humidité relative vérifiant $\varphi_1$=45%.

L'étape c) est exécutée dans un four 4, la température de recuit thermique étant égale à 300°C. La montée graduelle en température est exécutée selon une rampe de température de 10°C/minute. Le recuit thermique est appliqué à la température de recuit pendant 2 heures (phase de plateau). L'étape c) est exécutée selon le second mode de mise en œuvre, c'est-à-dire que l'étape c) est exécutée en injectant suffisamment de vapeur d'eau, à l'aide de l'injecteur 40, et en permanence -i.e. pendant toute la durée de l'étape c)-, dans la seconde atmosphère gazeuse 3 de sorte que $\varphi_2$ est égal à 100%.

L'énergie d'adhérence est mesurée à l'issue de l'étape c) grâce à la technique du double levier à déplacement imposé (DCB « *Double Cantilever Beam under prescribed displacement*» en langue anglaise), impliquant une découpe de deux poutres :

- une poutre de 1 cm de large passant par les bords des deux substrats 1, 2 collés,
- une poutre de 1 cm de large passant par une portion centrale des deux substrats 1, 2 collés.

On mesure une énergie d'adhérence de 4,8 J/m² au sur les bords, et une énergie d'adhérence de 4,7 J/m² sur la portion centrale, soit une différence de 100 mJ/m², valeur très inférieure à 700 mJ/m² de l'état de la technique, qui plus est pour un diamètre de substrat de 300 mm par rapport à un diamètre de 200 mm de l'état de la technique.

### Exemple de mise en œuvre n°2

Les premier et deuxième substrats 1, 2 sont deux tranches de silicium <001> de 300 mm de diamètre et de 775 $\mu$m d'épaisseur. Un des deux substrats 1, 2 comporte une couche superficielle 12, 22 d'oxyde obtenue par oxydation thermique, et d'une épaisseur de 145 nm. Les premier et deuxième substrats 1, 2 sont nettoyés et hydrolysés dans des bains d'eau déionisée enrichie en ozone dans une solution d'APM (« *Ammonia-Peroxyde Mixture* ») à 70°C.

Les premier et deuxième substrats 1, 2 sont collés lors de l'étape b) par adhésion directe à température ambiante, et à pression ambiante. La première atmosphère gazeuse (air ambiant) présente un premier taux d'humidité relative vérifiant $\varphi_1$=45%.

L'étape c) est exécutée dans un four 4, la température de recuit thermique étant égale à 300°C. La montée graduelle en température est exécutée selon une rampe de température de 10°C/minute. Le recuit thermique est appliqué à la température de recuit pendant 2 heures (phase de plateau). L'étape c) est exécutée selon le premier mode de mise en œuvre, c'est-à-dire que l'étape c) est exécutée en injectant :

- une quantité de vapeur d'eau dans la seconde atmosphère gazeuse 3, pendant la montée graduelle en température jusqu'à 120°C, telle que $\varphi_2$ est maintenu égal à 50% ;
- une quantité de vapeur d'eau dans la seconde atmosphère gazeuse 3, de 120°C à la phase de plateau, telle que $\varphi_2$ est égal à 100%.

L'énergie d'adhérence est mesurée à l'issue de l'étape c) grâce à la technique du double levier à déplacement imposé (DCB « *Double Cantilever Beam under prescribed displacement* » en langue anglaise), impliquant une découpe de deux poutres :

- une poutre de 1 cm de large passant par les bords des deux substrats 1, 2 collés,
- une poutre de 1 cm de large passant par une portion centrale des deux substrats 1, 2 collés.

On mesure une énergie d'adhérence de 4,8 J/m² au sur les bords, et une énergie d'adhérence de 4,5 J/m² sur la portion centrale, soit une différence de 300 mJ/m², valeur très inférieure à 700 mJ/m² de l'état de la technique, qui plus est pour un diamètre de substrat de 300 mm par rapport à un diamètre de 200 mm de l'état de la technique.

L'invention ne se limite pas aux modes de réalisation exposés. L'homme du métier est mis à même de considérer leurs combinaisons techniquement opérantes, et de leur substituer des équivalents.

### Revendications

1. Procédé de collage par adhésion directe d'un premier substrat (1) à un deuxième substrat (2), comportant les étapes successives :

   a) prévoir les premier et deuxième substrats (1, 2), comprenant chacun une première surface (10, 20) et une seconde surface (11, 21) opposée ;
   b) coller le premier substrat (1) au deuxième substrat (2) par une adhésion directe entre les premières surfaces (10, 20) des premier et deuxième substrats (1, 2), l'étape b) étant exécutée à une température comprise entre 20°C et 30°C sous une première atmosphère gazeuse présentant un premier taux d'humidité relative, noté $\varphi_1$ ;
   c) appliquer un recuit thermique aux premier et deuxième substrats (1, 2) collés, à une température de recuit thermique comprise entre 100°C et 700°C, l'étape c) étant exécutée sous une seconde atmosphère gazeuse (3) présentant un second taux d'humidité relative, noté $\varphi_2$, **caractérisé en ce que** les premier et deuxième substrats (1, 2) collés sont maintenus après l'étape b), y compris lors de l'exécution de l'étape c), sous une atmosphère présentant un taux d'humidité relative $\varphi_2$ supérieur ou égal à $\varphi_1$, vérifiant $\varphi_2 \geq \varphi_1$, de manière à homogénéiser l'énergie d'adhérence des premières surfaces (10, 20) des premier et deuxième substrats (1, 2).

2. Procédé selon la revendication 1, dans lequel l'eau possède une pression de vapeur saturante au sein de la seconde atmosphère gazeuse (3), notée $P_{sat}$, et dans lequel l'étape c) comporte les étapes :

   $c_1$) augmenter progressivement une température de chauffage de la seconde atmosphère gazeuse (3) jusqu'à atteindre la température de recuit thermique ;
   $c_2$) mesurer des températures de chauffage progressives au cours de l'étape $c_1$), et déterminer $P_{sat}$ pour les températures de chauffage progressives mesurées ;
   $c_3$) augmenter progressivement, au cours de l'étape $c_1$), la pression partielle de vapeur d'eau, notée $p_v$, au sein de la seconde atmosphère gazeuse (3) de sorte que $p_v \geq P_{sat} \varphi_1$.

**3.** Procédé selon la revendication 1, dans lequel l'étape c) est exécutée de manière à saturer la seconde atmosphère gazeuse (3) de vapeur d'eau de sorte que $\varphi_2$ est égal à 100%.

**4.** Procédé selon l'une des revendications 1 à 3, dans lequel l'étape c) est exécutée de sorte que la seconde atmosphère gazeuse (3) présente une pression constante.

**5.** Procédé selon l'une des revendications 1 à 4, dans lequel les première et seconde atmosphères gazeuses (3) comportent de l'air.

**6.** Procédé selon l'une des revendications 1 à 5, dans lequel l'étape c) est exécutée dans un four (4) injectant une vapeur d'eau, produite par ultrasons, dans la seconde atmosphère gazeuse (3).

**7.** Procédé selon l'une des revendications 1 à 6, dans lequel la température de recuit thermique est comprise entre 100°C et 500°C, plus préférentiellement comprise entre 200°C et 400°C, encore plus préférentiellement comprise entre 250°C et 350°C.

**8.** Procédé selon l'une des revendications 1 à 7, dans lequel :

- l'étape a) comporte une étape $a_1$) consistant à implanter des espèces gazeuses dans le premier substrat (1), à travers la première surface (10), de manière à former une zone de fragilisation (ZS), une couche utile (5) étant délimitée par la zone de fragilisation (ZS) et par la première surface (10) du premier substrat (1) ; et
- le recuit thermique est appliqué lors de l'étape c) selon un budget thermique adapté pour fracturer le premier substrat (1) suivant la zone de fragilisation (ZS) de manière à exposer la couche utile (5).

**9.** Procédé selon l'une des revendications 1 à 7, dans lequel :

- l'étape a) comporte une étape $a_1$) consistant à implanter des espèces gazeuses dans le premier substrat (1), à travers la première surface (10), de manière à former une zone de fragilisation (ZS), une couche utile (5) étant délimitée par la zone de fragilisation (ZS) et par la première surface (10) du premier substrat (1) ; et
- l'étape c) est suivie d'une étape d) consistant à fracturer le premier substrat (1) suivant la zone de fragilisation (ZS) de manière à exposer la couche utile (5).

**10.** Procédé selon l'une des revendications 1 à 9, dans lequel les premières surfaces (10, 20) des premier et deuxième substrats (1, 2) sont réalisées dans un matériau sélectionné parmi Si, $SiO_2$, Ge, $Al_2O_3$, SiC, AsGa, InP, GaN, $LiNbO_3$, $LiTaO_3$.

**Patentansprüche**

**1.** Verfahren zum Kleben, indem ein erstes Substrat (1) unmittelbar auf einem zweiten Substrat (2) zum Haften gebracht wird, wobei es nacheinander die folgenden Schritte aufweist:

a) Bereitstellen des ersten und des zweiten Substrats (1, 2), wobei jedes davon eine erste Fläche (10, 20) und eine gegenüberliegende zweite Fläche (11, 21) umfasst;
b) Kleben des ersten Substrats (1) auf das zweite Substrat (2), indem zwischen den ersten Flächen (10, 20) des ersten und des zweiten Substrats (1, 2) unmittelbar eine Haftverbindung hergestellt wird, wobei der Schritt b) bei einer Temperatur im Bereich von 20 °C bis 30 °C unter einer ersten gasförmigen Atmosphäre durchgeführt wird einen ersten relativen Feuchtigkeitsgehalt aufweist, welcher mit $\varphi_1$ bezeichnet wird;
c) Anwenden einer Wärmebehandlung auf die verklebten ersten und zweiten Substrate (1, 2), bei einer Wärmebehandlungstemperatur im Bereich von 100 °C bis 700 °C, wobei der Schritt c) unter einer zweiten gasförmigen Atmosphäre (3) durchgeführt wird, die einen zweiten relativen Feuchtigkeitsgehalt aufweist, welcher mit $\varphi_2$, bezeichnet wird, **dadurch gekennzeichnet, dass** die verklebten ersten und zweiten Substrate (1, 2) nach dem Schritt b), auch während der Durchführung des Schrittes c), unter einer Atmosphäre gehalten werden, die einen relativen Feuchtigkeitsgehalt $\varphi_2$ aufweist, der größer oder gleich $\varphi_1$ ist, wobei die Bedingung $\varphi_2 \geq \varphi_1$ erfüllt sein muss, um auf diese Weise die Haftenergie der ersten Flächen (10, 20) des ersten und des zweiten Substrats (1, 2) zu homogenisieren.

**2.** Verfahren nach Anspruch 1, wobei das Wasser innerhalb der zweiten gasförmigen Atmosphäre (3) einen Sättigungsdampfdruck besitzt, welcher mit $P_{sat}$ bezeichnet wird,
und wobei der Schritt c) die folgenden Schritte aufweist:

$c_1$) fortschreitendes Erhöhen einer Aufheiztemperatur der zweiten gasförmigen Atmosphäre (3), bis die Temperatur der Wärmebehandlung erreicht ist;
$c_2$) Messen der fortschreitenden Aufheiztemperaturen im Verlauf des Schrittes $c_1$) und Bestimmen von $P_{sat}$ für die gemessenen fortschreiten-

den Aufheiztemperaturen;

$c_3$) fortschreitendes Erhöhen, im Verlauf des Schrittes $c_1$, des Wasserdampf-Partialdrucks, welcher mit $p_v$ bezeichnet wird, innerhalb der zweiten gasförmigen Atmosphäre (3) derart, dass $p_v \geq P_{sat} \, \varphi_1$ ist.

3. Verfahren nach Anspruch 1, wobei der Schritt c) derart durchgeführt wird, dass die zweite gasförmige Atmosphäre (3) an Wasserdampf gesättigt wird, sodass $\varphi_2$ gleich 100 % ist.

4. Verfahren nach einem der Ansprüche 1 bis 3, wobei der Schritt c) derart durchgeführt wird, dass die zweite Atmosphäre (3) einen konstanten Druck aufweist.

5. Verfahren nach einem der Ansprüche 1 bis 4, wobei die erste und die zweite gasförmige Atmosphäre (3) Luft aufweisen.

6. Verfahren nach einem der Ansprüche 1 bis 5, wobei der Schritt c) in einem Ofen (4) durchgeführt wird, wobei ein Wasserdampf, welcher mittels Ultraschall erzeugt wird, in die zweite gasförmige Atmosphäre (3) eingeleitet wird

7. Verfahren nach einem der Ansprüche 1 bis 6, wobei die Wärmebehandlungstemperatur im Bereich von 100 °C bis 500 °C, stärker bevorzugt im Bereich von 200 °C bis 400 °C, noch stärker bevorzugt im Bereich von 250 °C bis 350 °C liegt.

8. Verfahren nach einem der Ansprüche 1 bis 7, wobei:

- der Schritt a) einen Schritt $a_1$) aufweist, der darin besteht, durch die erste Fläche (10) gasförmige Spezies in das erste Substrat (1) einzubringen, sodass sich ein Versprödungsbereich (ZS) bildet, wobei eine Nutzschicht (5) von dem Versprödungsbereich (ZS) und von der ersten Fläche (10) des ersten Substrats (1) begrenzt wird; und
- die Wärmebehandlung während des Schrittes c) gemäß einem Wärmebudget zur Anwendung gebracht wird, das dafür geeignet ist, das erste Substrat (1) entlang des Versprödungsbereichs (ZS) derart aufzubrechen, dass die Nutzschicht (5) freigelegt wird.

9. Verfahren nach einem der Ansprüche 1 bis 7, wobei:

- der Schritt a) einen Schritt $a_1$) aufweist, der darin besteht, durch die erste Fläche (10) gasförmige Spezies in das erste Substrat (1) einzubringen, sodass sich ein Versprödungsbereich (ZS) bildet, wobei eine Nutzschicht (5) von dem Versprödungsbereich (ZS) und von der ersten Fläche (10) des ersten Substrats (1) begrenzt wird; und
- auf den Schritt c) ein Schritt d) folgt, der darin besteht, das erste Substrat (1) entlang des Versprödungsbereichs (ZS) derart aufzubrechen, dass die Nutzschicht (5) freigelegt wird.

10. Verfahren nach einem der Ansprüche 1 bis 9, wobei die ersten Flächen (10, 20) des ersten und des zweiten Substrats (1, 2) aus einem Material hergestellt sind, welches aus Si, $SiO_2$, Ge, $Al_2O_3$, SiC, AsGa, InP, GaN, $LiNbO_3$, $LiTaO_3$ ausgewählt ist.

## Claims

1. Process for attaching a first substrate (1) to a second substrate (2) by direct bonding including the successive steps of:

a) providing the first and second substrates (1, 2), each comprising a first surface (10, 20) and an opposite second surface (11, 21);
b) bonding the first substrate (1) to the second substrate (2) by direct bonding between the first surfaces (10, 20) of the first and second substrates (1, 2), step b) being carried out at a temperature of between 20°C and 30°C under a first gaseous atmosphere having a first relative humidity level denoted by $\varphi_1$;
c) applying a thermal annealing treatment to the bonded first and second substrates (1, 2) at a thermal annealing temperature of between 100°C and 700°C, step c) being carried out under a second gaseous atmosphere (3) having a second humidity level denoted by $\varphi_2$,

**characterized in that** the bonded first and second substrates (1, 2) are maintained after step b), including during step c), under an atmosphere having a relative humidity level $\varphi_2$, superior or equal to $\varphi_1$, satisfying $\varphi_2 \geq \varphi_1$, such that the adhesion energy of the first surfaces (10, 20) of the first and second substrates (1, 2) is homogenized.

2. Process according to Claim 1, wherein water exhibits a saturated vapour pressure within the second gaseous atmosphere (3) denoted by $P_{sat}$, and wherein step c) includes the steps of:

$c_1$) gradually increasing a heating temperature of the second gaseous atmosphere (3) until reaching the thermal annealing temperature;
$c_2$) measuring progressive heating temperatures over step $c_1$) and determining $P_{sat}$ for the measured progressive heating temperatures;
$c_3$) gradually increasing, over step $c_1$), the par-

tial water vapour pressure, denoted by $p_v$, within the second gaseous atmosphere (3) such that $p_v \geq P_{sat} \varphi_1$.

3. Process according to Claim 1, wherein $\varphi_2$ is equal to 100%.

4. Process according to one of Claims 1 to 3, wherein step c) is carried out such that the second gaseous atmosphere (3) exhibits a constant pressure.

5. Process according to one of Claims 1 to 4, wherein the first and second gaseous atmospheres (3) include air.

6. Process according to one of Claims 1 to 5, wherein step c) is carried out in an oven (4) injecting water vapour, produced by means of ultrasound, into the second gaseous atmosphere (3).

7. Process according to one of Claims 1 to 6, wherein the thermal annealing temperature is between 100°C and 500°C, more preferably between 200°C and 400°C, even more preferentially between 250°C and 350°C.

8. Process according to one of Claims 1 to 7, wherein:

   - step a) includes a step $a_1$) consisting in implanting gaseous species into the first substrate (1), through the first surface (10), so as to form a weakened zone (ZS), a useful layer (5) being delimited by the weakened zone (ZS) and by the first surface (10) of the first substrate (1); and
   - the thermal annealing treatment is applied in step c) according to a thermal budget that is suitable for splitting the first substrate (1) along the weakened zone (ZS) so as to expose the useful layer (5).

9. Process according to one of Claims 1 to 7, wherein:

   - step a) includes a step $a_1$) consisting in implanting gaseous species into the first substrate (1), through the first surface (10), so as to form a weakened zone (ZS), a useful layer (5) being delimited by the weakened zone (ZS) and by the first surface (10) of the first substrate (1); and
   - step c) is followed by a step d) consisting in splitting the first substrate (1) along the weakened zone (ZS) so as to expose the useful layer (5).

10. Process according to one of Claims 1 to 9, wherein the first surfaces (10, 20) of the first and second substrates (1, 2) are produced in a material selected from Si, $SiO_2$, Ge, $Al_2O_3$, SiC, AsGa, InP, GaN, $LiNbO_3$, $LiTaO_3$.

*Fig. 1*

*Fig. 2*

*Fig. 3a*

*Fig. 3b*

*Fig. 3c*

*Fig. 3d*

*Fig. 3e*

**EP 3 496 135 B1**

## RÉFÉRENCES CITÉES DANS LA DESCRIPTION

**Documents brevets cités dans la description**

- US 2016233125 A1
- US 2017133347 A1
- US 2015194337 A1
- US 2014235031 A1